# EUROPEAN PATENT APPLICATION

(11) **EP 3 573 093 A1**
(43) Date of publication of application: **27.11.2019**
(21) Application number: 17892532.7
(22) Date of filing: 28.11.2017
(51) Int. Cl.: H01L 21/673

(54) **ARTICLE RELAYING DEVICE AND STOCKER**

(30) Priority: 23.01.2017 JP 2017009445
(71) Applicant: Murata Machinery, Ltd., Kyoto-shi, Kyoto 601-8326 (JP)
(72) Inventor: OGO, Haruki, Inuyama-shi Aichi 484-8502 (JP); GOTO, Fumiki, Inuyama-shi Aichi 484-8502 (JP)
(74) Representative: Weickmann & Weickmann PartmbB
(86) International application number: PCT/JP2017/042612
(87) International publication number: WO 2018/135137

(57) **Abstract**

[Problem] To improve workability by improving the visibility of the rear side of an opening and making it easy for an operator to check an article, such as a container.

[Solving means] An article relay apparatus 100 that is disposed on an outside wall 111 separating the interior and exterior of a stocker 200 and relays an article M between the facility interior and an operator. The article relay apparatus 100 includes an opening 10 that faces and is open to an operator passage R located outside the outside wall, a placement table 20 that is disposed in the rear side in the depth direction D of the opening and on which the article is to be placed, a first cover 31 disposed in a position that is above the opening and is on the front side in the depth direction of the opening, the first cover 31 serving as a part of the outside wall, and a second cover 41 that is disposed between the first cover and the opening, serves as a part of the outside wall, and has a shape extending toward a rear side in the depth direction as going downward.

## Description

### TECHNICAL FIELD

The present invention relates to an article relay apparatus and a stocker.

### BACKGROUND ART

In semiconductor manufacturing plants or the like, containers containing reticles, semiconductor wafers, or the like are transported into or out of facilities, such as a stocker (storage apparatus) and an exposure apparatus. The transportation of the containers into or out of the facilities, which is typically performed by a transport system, may, however, be performed by an operator. These facilities are known to include article relay apparatuses (manual ports) to assist the operator in transporting containers into or out of the facilities (for example, see Patent Literature 1).

Such an article relay apparatus is disposed, for example, on an outside wall separating the interior and exterior of a stocker and relays an article (container) between the facility interior and the operator. The article relay apparatus is provided with an opening that faces and is open to an operator passage located outside the outside wall, and a placement table on which an article is to be placed is disposed on a rear side in a depth direction from the opening. A control panel or the like is disposed above the opening, and a cover for covering the control panel is disposed as a part of the outside wall.

### Citation List

### Patent Literature

[Patent Literature 1] Japanese Patent No. 5332930

### SUMMARY OF THE INVENTION

### Technical Problem

For example, if the article is a container (reticle pod) containing reticles, and the container is relayed using the above article relay apparatus, the height of a placement table having the container placed thereon is set in accordance with a standard, such as SEMI. The height is much lower than the operator's eye level. Also, a reticle pod contains one or some reticles and therefore the vertical height thereof is small. Therefore, the vertical size of the opening of the article relay apparatus is also set to a small size. Also, the cover covering the control panel or the like is disposed above the opening, as described above, and protrudes from the outside wall of the facility. Therefore, the operator has difficulty in visually recognizing the rear side of the opening while standing and thus difficulty in seeing a container placed on the article relay apparatus, resulting in a reduction in the workability.

An object of the present invention is to provide an article relay apparatus and stocker that are able to improve workability by improving the visibility of the rear side of an opening and thus making it easy for an operator to identify an article, such as a container.

### Solution to Problem

An article relay apparatus of the present invention is an article relay apparatus that is disposed on an outside wall separating an interior and an exterior of a facility and relays an article between the interior of the facility and an operator. The article relay apparatus includes an opening that faces and is open to an operator passage located outside the outside wall, a placement table that is disposed on a rear side in a depth direction with respect to the opening and on which an article is to be placed, a first cover disposed in a position that is above the opening and is on a front side in the depth direction with respect to the opening, the first cover serving as a part of the outside wall, and a second cover that is disposed between the first cover and the opening, serves as a part of the outside wall, and has a shape extending toward a rear side in the depth direction as going downward.

The article relay apparatus may include a movement mechanism that moves the placement table between a first position that is on a front side in the depth direction and a second position that is on a rear side in the depth direction with respect to the first position and is a position in which an article is received from and passed to a transporter disposed in the interior of the facility. The first position may be a position in which at least part of an article placed on the placement table is on a front side in the depth direction with respect to a virtual plane that includes an upper end of the opening and is in contact with the second cover, and the second position may be a position that is on a rear side in the depth direction with respect to the first position. The first position may be a position that is on a rear side in the depth direction with respect to the first cover, and the movement mechanism may be able to move the placement table to the first position in a direction toward the front side in the depth direction. The article relay apparatus may include an outside air supplier that supplies outside air outside the outside wall to a rear side in the depth direction of the opening. An outside air inlet of the outside air supplier may be formed in a portion of the second cover.

A stocker of the present invention includes any one of the article relay apparatuses. The stocker may include multiple shelves on each of which the article is to be placed, the shelves being contained in the stocker, and at least one of the shelves is disposed in a position that is on a rear side in the depth direction with respect to the first cover and is above the placement table.

### Advantageous Effects of the Invention

In the article relay apparatus of the present invention, the second cover has the shape extending toward a rear side in the depth direction as going downward from the first cover. Thus, the operator is able to visually recognize a part on the rear side of the opening obliquely from above while standing. As a result, the operator is able to easily check that the article is present on the rear side of the opening and thus to improve the workability of the article receiving/passing work or the like.

If the article relay apparatus includes the movement mechanism that moves the placement table between the first position that is on the front side in the depth direction and the second position that is on a rear side in the depth direction with respect to the first position and is a position in which an article is received from and passed to the transporter disposed in the interior of the facility, locating the placement table in the first position allows the operator to easily receive and pass an article from and to the placement table and locating the placement table in the second position allows the transporter to reliably receive and pass an article from and to the placement table. If the first position is the position in which at least part of an article placed on the placement table is on a front side in the depth direction with respect to the virtual plane that includes the upper end of the opening and is in contact with the second cover and the second position is the position that is on a rear side in the depth direction with respect to the first position, the operator is able to visually recognize a part of the article placed on the placement table located in the first position, obliquely from above the opening and to easily identify the presence of the article.

If the first position is the position that is on a rear side in the depth direction with respect to the first cover and is the front-side limit position in the depth direction of the movement mechanism, the placement table located in the first position can be prevented from protruding from the first cover. If the article relay apparatus includes the outside air supplier that supplies outside air outside the outside wall to the rear side in the depth direction of the opening, the atmosphere in the rear of the opening can be set to a state similar to the outside air. If the outside air inlet of the outside air supplier is formed in a portion of the second cover, a reduction in the length of the duct or the like and thus a reduction in the cost are made possible, since the outside air inlet is formed in the second cover close to the opening.

The stocker of the present invention includes any one of the article relay apparatuses. Thus, the operator is allowed to receive and pass an article from and to the stocker with improved workability. If the stocker includes the multiple shelves on each of which the article is to be placed, the shelves being contained in the stocker, and at least one of the shelves is disposed in the position that is on a rear side in the depth direction with respect to the first cover and is above the placement table, articles can be efficiently contained in the stocker.

### BRIEF DESCRIPTION OF DRAWINGS

FIG. 1 is a side view showing an example of an article relay apparatus of an embodiment.
FIG. 2 is a front view of the article relay apparatus shown in FIG. 1.
FIG. 3(A) is a plan view showing a case in which a placement table is located in a first position, and FIG. 3(B) is a plan view showing a case in which the placement table is located in a second position.
FIG. 4(A) is a side view showing a case in which the placement table is located in the first position, and FIG. 4(B) is a side view showing a case in which the placement table is located in the second position.
FIG. 5 is a sectional view showing an example of an outside air supplier.
FIG. 6 is a perspective view showing an example of a stocker of the embodiment.
FIG. 7 is a drawing showing an example of the internal configuration of the stocker.

### DESCRIPTION OF EMBODIMENTS

Now, an embodiment of the present invention will be described with reference to the drawings. However, the present invention is not limited to the embodiment. To clarify the embodiment, the drawings are scaled as necessary, for example, partially enlarged or highlighted.

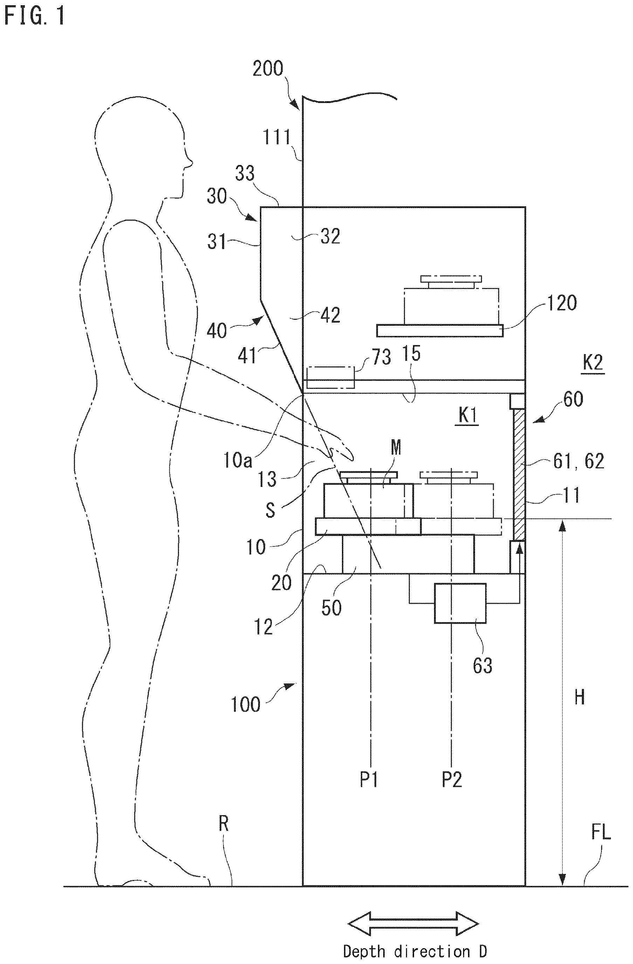

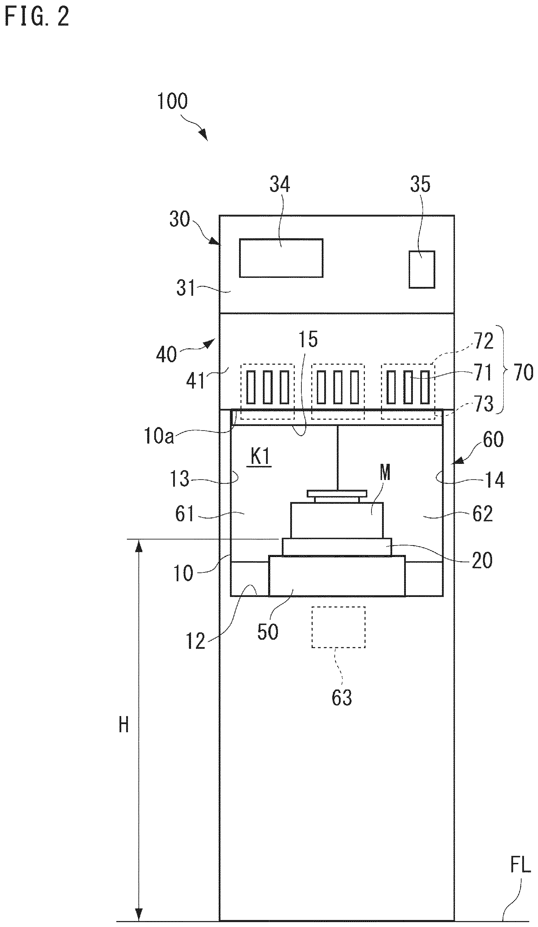

FIGS. 1 and 2 are drawings showing an example of an article relay apparatus of the present embodiment, in which FIG. 1 is a side view; and FIG. 2 is a front view. As shown in FIGS. 1 and 2, the article relay apparatus 100 is disposed on a part of an outside wall 111 separating the interior and exterior of a stocker 200, which is one of facilities, and relays an article M between the stocker interior (facility interior) K2 and the operator. For example, the article relay apparatus 100 is disposed on a part of the outside wall 111, the part facing an operator passage R. In the following description, it is assumed that the side facing the passage R, of the article relay apparatus 100, is the front side thereof.

The type of the facility is not limited to the stocker 200 as described in the present embodiment, and may be, for example, a facility including a processor, such as an exposure apparatus. The article M is not limited to a reticle pod, such as a reticle pod (container) containing reticles used in an exposure apparatus, and may be, for example, a FOUP containing wafers. The article M contains one or more reticles and is formed with a vertical height so as to be able to contain one or some reticles.

As shown in FIGS. 1 and 2, the article relay apparatus 100 includes an opening 10, a placement table 20, a movement mechanism 50, and a shutter mechanism 60. A first cover 30, a second cover 40, and an outside air supplier 70 are disposed on the stocker 200 as a facility so as to correspond to the article relay apparatus 100. The first cover 30 and the second cover 40 form a part of the outside wall 111 of the stocker 200. The opening 10 faces and is open to the operator passage R located outside the outside wall 111. That is, the opening 10 is disposed on the front side of the article relay apparatus 100. The opening 10 has a rectangular shape in front view. The vertical size of the opening 10 is set to a size such that the article M can pass through the opening 10. In this specification, the term "rectangular shape" includes rectangles and squares.

The opening 10 is provided so as to penetrate the outside wall 111 in the depth direction D. The article relay apparatus 100 has an inner opening 11 on a rear side in the depth direction D. The inner opening 11 has a rectangular shape, as with the opening 10, and is formed on the stocker interior K2 side. The article relay apparatus 100 has an apparatus interior K1 formed by a bottom surface 12, side surfaces 13, 14, and a top surface 15 between the opening 10 and the inner opening 11.

The placement table 20 has the article M placed thereon. The placement table 20 is disposed on a rear side in the depth direction D with respect to the opening 10 in the apparatus interior K1. The placement table 20 can be moved toward the rear and front sides in the depth direction D along a guide (not shown). The height H of the placement table 20 having the article M placed thereon is set on the basis of a standard, such as SEMI. The height H of the placement table 20 is set to a lower height than the eye level of the operator.

The first cover 30 is formed of, for example, a metal or resin and serves as a part of the outside wall 111. The first cover 30 is disposed in a position above the opening 10 and on a front side in the depth direction D with respect to the opening 10 so as to protrude outward from the outside wall 111. The first cover 30 includes a front surface 31, a side surface 32, and a top surface 33. The front surface 31, the side surface 32, and the top surface 33 have flat shapes and are disposed so as to be perpendicular to each other.

The front surface 31 is disposed along the vertical direction and has a rectangular shape in front view. The front surface 31 is disposed at a height close to the eye level of the operator. The front surface 31 has an operation panel 34 and a switch 35 disposed thereon (see FIG. 2). The operation panel 34 includes, for example, an input part that operates the components of the article relay apparatus 100 and a display part that displays images, characters, or the like. The input part is, for example, a touchscreen, lever, or button. The display part is, for example, a liquid crystal display. The switch 35 is used to switch between the activation and deactivation of the outside air supplier 70 (to be discussed later). Since the operation panel 34 or the switch 35 is disposed on the front surface 31 close to the eye level of the operator, the operability and operator convenience are increased. The first cover 30 may contain, for example, a control board. Note that the switch 35 does not have to be provided. For example, the outside air supplier 70 may be controlled so as to activate a fan 73 when shutters 61, 62 (to be discussed later) are open.

As with the first cover 30, the second cover 40 is formed of, for example, a metal or resin and serves as a part of the outside wall 111, and is disposed between the first cover 30 and the opening 10. For example, the second cover 40 may be formed integrally with the first cover 30, or may be formed as a different object and coupled to the first cover 30 using a fastening member. The first cover 30 and the second cover 40 are joined together without spaces and separate the interior and exterior of the stocker 200, as with the outside wall 111.

The second cover 40 includes a slope 41 and a side surface 42. The slope 41 has a shape extending toward a rear side in the depth direction D as going downward. The slope 41 is disposed so as to extend from the lower end 31b of the first cover 30 to the opening 10. Accordingly, the slope 41 is disposed so as to be inclined with respect to the front surface 31. While the lower end 41b of the slope 41 is disposed at a height matching the height of the upper end 10a of the opening 10, the slope 41 may be configured otherwise. The slope 41 of the second cover 40 prevents the opening 10 from being hidden when viewed from a higher position while ensuring a space in the interior of the facility.

The slope 41 is a rectangular, flat member, but is not limited to such a shape and may have a curved surface or a shape in which multiple flat or curved surfaces are combined. In the present embodiment, the slope 41 has a shape in which the lower end 31b of the front surface 31 and the upper end 10a of the opening 10 are connected by a flat surface.

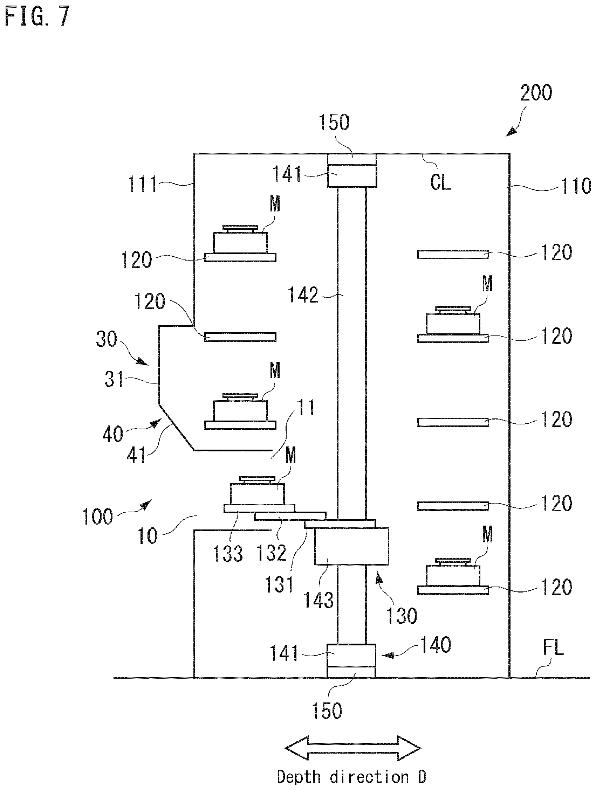

The movement mechanism 50 moves the placement table 20 between a first position P1 and a second position P2 in the depth direction D. The first position P1 is a position in which at least part of the article M placed on the placement table 20 is on a front side in the depth direction D with respect to a virtual plane S that includes the upper end of the opening 10 and is in contact with the second cover 40. In the present embodiment, the virtual plane S is a plane including the slope 41. The first position P1 is on a rear side in the depth direction D with respect to the first cover 30. The second position P2 is on a rear side in the depth direction D with respect to the first position P1. The second position P2 is also a position in which the article M is received from and passed to a transporter (see FIG. 7) disposed in the stocker interior K2.

The movement mechanism 50 is a mechanism that is able to move the placement table 20 in a straight-line direction along the guide (not shown). Drive apparatuses that represent such a mechanism include, for example, a ball screw mechanism, a linear motor mechanism, a rotary belt mechanism, and an air cylinder mechanism. The movement direction, the amount of movement, the movement timing, and the like of the movement mechanism 50 are controlled by a controller 63. The controller 63 is shown below the movement mechanism 50 in FIG. 1 but may be disposed, for example, inside the second cover 40 or outside the article relay apparatus 100. The controller 63 may be electrically connected to the controller of the stocker 200.

When the placement table 20 is located in the first position P1 by activating the movement mechanism 50, the placement table 20 is located close to the opening 10, allowing the operator to easily receive and pass the article M from and onto the placement table 20. In such a case, the operator is able to see, obliquely from above, a part of the article M placed on the placement table 20 in a position on a front side with respect to the virtual plane S and thus to easily identify the presence of the article M. That is, the operator does not need to identify the article M by making a posture change, such as squatting down and then looking inside, and thus is able to improve workability.

The first position P1 is the front-side movement limit position in the movement range of the placement table 20. Such a configuration prevents the placement table 20 (or article M) from protruding outward from the first cover 30. The second position P2 is the rear-side movement limit position in the movement range of the placement table 20, as well as is a position in which the article M can be received from and passed to the article transporter (not shown) disposed in the stocker interior K2. Thus, when the placement table 20 is located in the second position P2, the article can be reliably received from and passed to the article transporter in the stocker interior K2.

The shutter mechanism 60 is disposed on a rear side in the depth direction in the apparatus interior K1. The shutter mechanism 60 opens and closes between the apparatus interior K1 of the article relay apparatus 100 and the stocker interior K2 of the stocker 200. The shutter mechanism 60 includes the shutters 61, 62. The shutters 61, 62 each consist of a curved metal or resin plate.

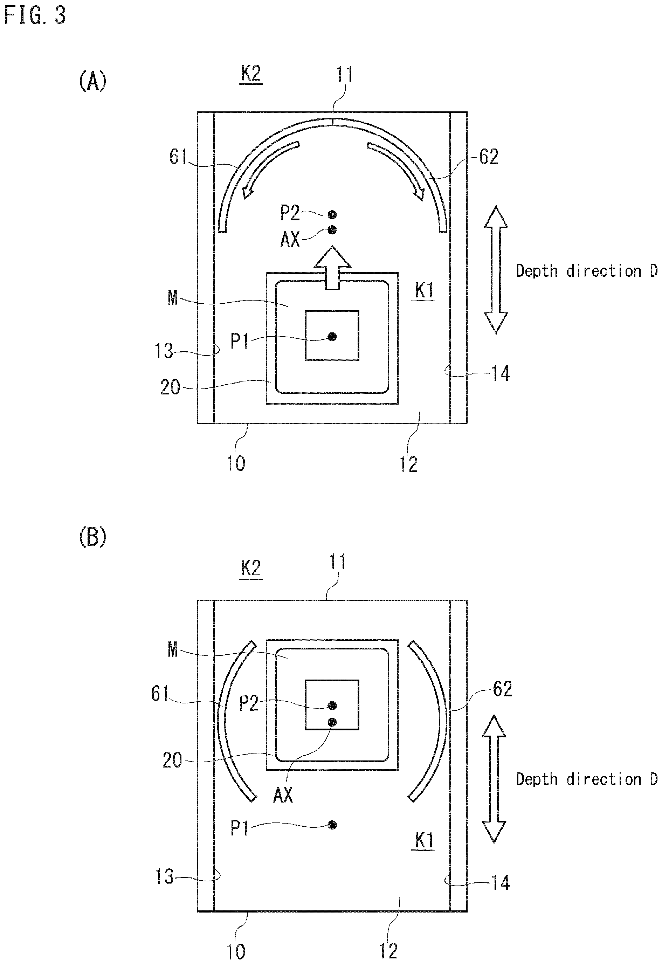

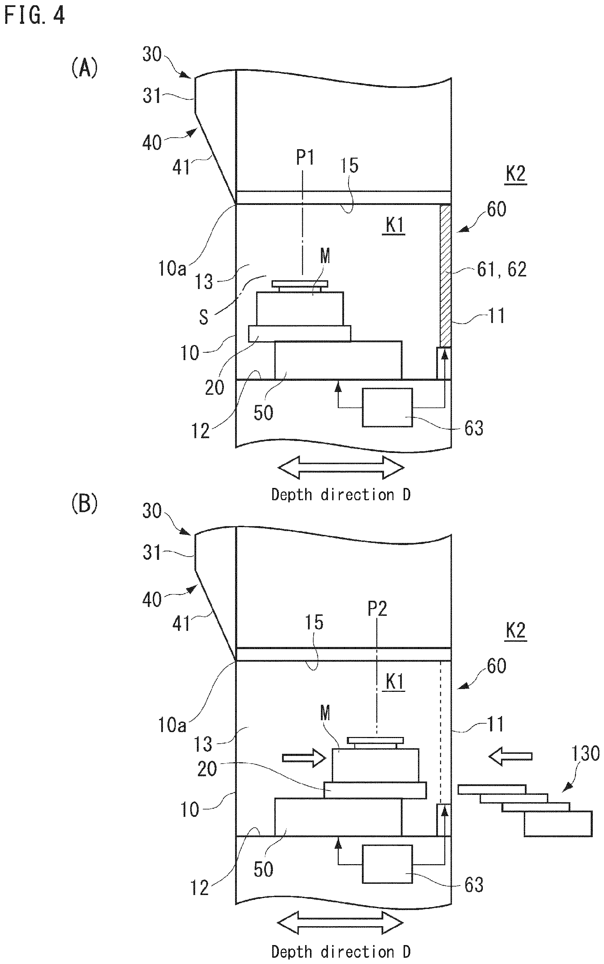

FIGS. 3(A), 3(B), 4(A), and 4(B) are drawings showing the operation of the article relay apparatus of the present embodiment. FIGS. 3(A) and 3(B) show states seen from above. FIGS. 4(A) and 4(B) show states seen from a side. The shutters 61, 62 can be moved in revolving directions around a vertical central axis AX by a drive mechanism (not shown). The shutters 61, 62 are able to move in an interlocked manner. The controller 63 controls the opening/closing of the shutters 61, 62 by driving the drive mechanism. For example, the controller 63 may perform control so that the shutters 61, 62 are closed when the placement table 20 is located in the first position P1 and is opened when the placement table 20 is moved to the second position P2.

As shown in FIGS. 3(A) and 4(A), in a closed state, the shutters 61, 62 are disposed so as to block the inner opening 11 with opposed edges 61a, 62a thereof in contact with each other. The edges 61a, 62a of the shutters 61, 62 may be provided with elastic members. By closing the shutters 61, 62, the apparatus interior K1 of the article relay apparatus 100 and the stocker interior K2 of the stocker 200 are separately sealed, preventing the atmosphere of the stocker interior K2 from flowing into the apparatus interior K1.

Next, as shown in FIG. 3(B) and 4(B), by opening the shutters 61, 62 and thus moving the shutters 61, 62 in revolving directions around the central axis AX, the inner opening 11 is opened. When the shutters 61, 62 are opened, they are retracted to positions that sandwich the second position P2. The shutter 61 is retracted along the side surface 13, and the shutter 62 is retracted along the side surface 14. The shutters 61, 62 are also retracted so as to be spaced from each other by a distance through which the article M can pass in the depth direction D. The track along which the shutters 61, 62 are opened and closed is set so as not to interfere with the track of the placement table 20. The shutters 61, 62 may be opened after the placement table 20 reaches the second position P2, or may be opened in the middle of movement of the placement table 20 to the second position P2.

The drive mechanism that opens and closes the shutters 61, 62 may be a link mechanism that transmits the drive force of the movement mechanism 50 to the opening/closing of the shutters 61, 62. The link mechanism may open and close the shutters 61, 62 with the movement of the placement table 20. Specifically, the link mechanism may be a mechanism that converts the movement in the straight-line direction of the placement table 20 into a movement in the direction of rotation around the central axis AX of the shutters 61, 62. The link mechanism may be configured to close the shutters 61, 62 when the placement table 20 is located in the first position P1 and to open the shutters 61, 62 when the placement table 20 is located in the second position P2.

The use of the link mechanism allows the shutters 61, 62 to be opened with the movement of the placement table 20 from the first position P1 to the second position P2 and allows the shutters 61, 62 to be closed with the movement of the placement table 20 from the second position P2 to the first position P1. This eliminates the need to use another drive source to open and close the shutters 61, 62, allowing for a reduction in the apparatus cost and for simplification of control performed by the controller 63.

The outside air supplier 70 is disposed in the vicinity of the opening 10 and above the apparatus interior K1. The outside air supplier 70 supplies outside air from outside the outside wall 111 to the apparatus interior K1 of the article relay apparatus 100. The outside air supplier 70 is able to render the air in the apparatus interior K1 similar to the outside air by supplying the outside air to the apparatus interior K1 of the opening 10. When the shutters 61, 62 are opened, the atmosphere of the stocker interior K2 flows into the apparatus interior K1. Therefore, by supplying the outside air to the apparatus interior K1, the air in the apparatus interior K1 can be rendered similar to the outside air. Even if the operator puts his or her head into the apparatus interior K1 for maintenance or the like of the apparatus, he or she is able to smoothly perform the work.

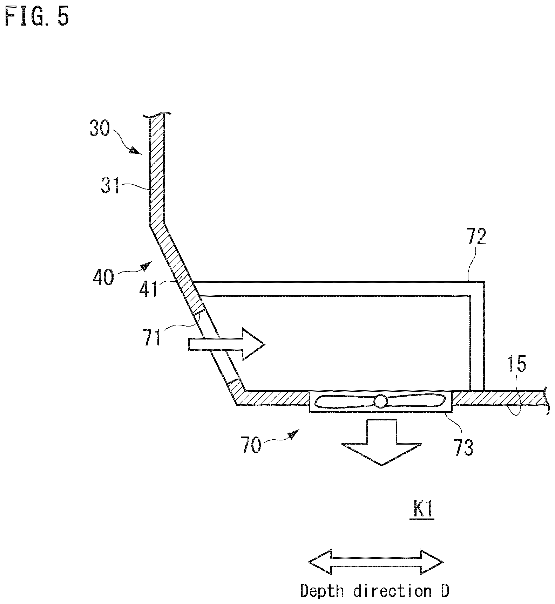

FIG. 5 is a sectional view showing an example of the outside air supplier 70. As shown in FIG. 5, the outside air supplier 70 includes multiple outside air inlets 71, a duct 72, and the fan 73. The outside air inlets 71 are formed in portions of the second cover 40. The outside air inlets 71 are formed in lower portions of the second cover 40 close to the opening 10 so as to be arranged horizontally (see FIG. 2). Thus, for example, the length of the duct 72 is reduced compared to when outside air inlets 71 are formed in the first cover 30, another portion of the outside wall 111, or the like, allowing for a reduction in the apparatus cost.

The duct 72 is disposed inside the second cover 40 and guides the outside air taken in through the outside air inlets 71 to a rear side in the depth direction D. The fan 73 is disposed so as to be oriented downward and feeds the outside air guided by the duct 72 to the apparatus interior K1 downward through the top surface 15. The operator may manually activate and deactivate the fan 73 using the switch 35 (see FIG. 2), or the controller 63 may control the activation and deactivation of the fan 73. If the controller 63 controls the activation of the fan 73, the control may be such that the fan 73 is activated after opening and then closing the shutters 61, 62.

Next, a case in which the operator transports an article M into the stocker 200 will be described. First, the transportation of an article M into the stocker 200 by the operator will be described. When transporting the article M, for example, the operator places the article M on a carriage or the like and transports the article M to the front of the article relay apparatus 100 through the passage R. The operator then locates the placement table 20 in the first position P1 by operating the operation panel 34. Note that the placement table 20 may be located in the first position P1 during the standby (non-use) of the article relay apparatus 100. In the case when the placement table 20 is located in the first position P1, the shutters 61, 62 are in a closed state.

The operator checks that an article M has not been placed on the placement table 20 yet while standing in front of the article relay apparatus 100. In such a case, the operator visually recognizes the apparatus interior K1 of the opening 10 by looking down thereinto obliquely from above. In the present embodiment, the second cover 40 includes the slope 41. Therefore, when the operator visually recognizes the apparatus interior K1 through the opening 10, there is no object that blocks the operator's line of sight. Thus, the operator is able to see the rear side of the opening 10 while standing and thus to easily check whether an article M is present on the placement table 20 in the first position P1.

If the operator confirms that an article M is absent on the placement table 20 in the first position P1, he or she lifts the article M from the carriage or the like and places the article M on the placement table 20. Since the placement table 20 is located in the first position P1 close to the opening 10, the operator is able to easily place the article M on the placement table 20. When placing the article M on the placement table 20, the operator may activate the outside air supplier 70 by operating the switch 35.

After placing the article M on the placement table 20, the operator moves the placement table 20 from the first position P1 to the second position P2 by operating the operation panel 34. The operation causes the movement mechanism 50 to move the placement table 20 having the article M placed thereon along the depth direction D and place the placement table 20 in the second position P2. The controller 63 or the above link mechanism opens the shutters 61, 62 with the movement of the placement table 20. The movement, for example, as shown in FIG. 4(B), enables the article M to be transported by a transporter 130 of the stocker 200. After the transporter 130 receives the article M, the controller 63 or the above link mechanism closes the shutters 61, 62.

Next, a case in which the operator transports an article M out of the stocker 200 will be described. When transporting the article M out of the stocker 200, the operator locates the placement table 20 in the second position P2 and opens the shutters 61, 62 using the controller 63 or the above link mechanism. After confirming that the shutters 61, 62 have been opened, the transporter 130 places the article M on the placement table 20 under the control of the stocker 200. After the transporter 130 retracts from the apparatus interior K1, the shutters 61, 62 are closed, and the placement table 20 having the article M placed thereon is moved from the second position P2 to the first position P1. Note that the outside air supplier 70 may be activated at the timing when the shutters 61, 62 are closed.

The operator checks that the placement table 20 having the article M placed thereon is located in the first position P1 while standing in front of the article relay apparatus 100. In such a case, the operator visually recognizes the apparatus interior K1 from the opening 10 by looking down thereinto obliquely from above. In the present embodiment, the second cover 40 includes the slope 41. Therefore, when the operator visually recognizes the first position P1, no object that blocks the operator's line of sight is disposed. Thus, the operator can easily check that the article M is placed on the placement table 20 in the first position P1.

After confirming that the article M is placed on the placement table 20 in the first position P1, the operator lifts the article M from the placement table 20 and takes out the article M through the opening 10. Since the placement table 20 is located in the first position P1 close to the opening 10, the operator is able to easily take out the article M from the placement table 20. After taking out the article M from the placement table 20, the operator places the article M on a carriage or the like previously prepared on the passage R.

Thus, according to the article relay apparatus 100 of the present embodiment, the second cover 40 has a shape extending toward a rear side in the depth direction D as going downward from the first cover 30. Thus, the operator is able to visually recognize a part of the rear side of the opening 10 obliquely from above while standing. Such a configuration allows the operator to easily check that the article M or placement table 20 is present on the rear side of the opening 10 and thus enables improvement in the workability of the article M receiving/passing work.

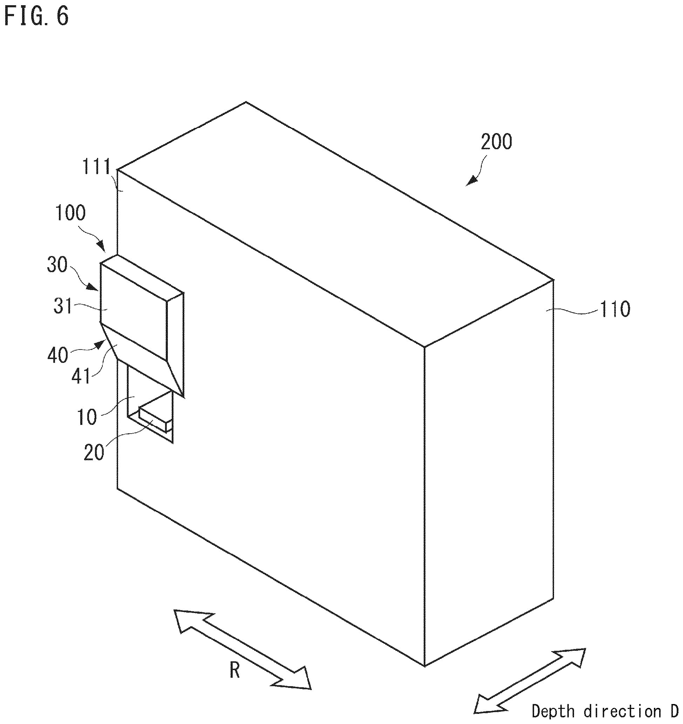

FIG. 6 is a perspective view showing an example of the stocker 200 of the present embodiment. FIG. 7 is a drawing showing an example of the internal configuration of the stocker 200. As shown in FIGS. 6 and 7, the stocker 200 is able to store multiple articles M. The stocker 200 includes a body 110, multiple shelves 120, the transporter 130, and a travel part 140. The stocker 200 includes a controller (not shown) that centrally controls the components.

The body 110 is disposed on the floor FL and includes the outside wall 111. The outside wall 111 is disposed so as to surround the space in the stocker and separates the interior and exterior of the stocker 200. The body 110 has the above article relay apparatus 100 on one surface of the outside wall 111.

Each shelf 120 has the article M placed thereon. The shelves 120 are supported by a column or the like (not shown) and disposed at multiple levels in the vertical direction (Z-direction) in the stocker. In the present embodiment, one or multiple lines of such multi-level shelves 120 are vertically disposed. At least one of the shelves 120 is disposed in a position that is on a rear side in the depth direction D with respect to the first cover 30 and is above the placement table 20. As seen above, an upper space in the article relay apparatus 100 is effectively used as an article M storage space.

Each shelf 120 has a notch. When transferring an article M onto a shelf 120 in the stocker 200, the transporter 130 passes the article M through the notch of the shelf 120. Note that if an article holder 133 of the transporter 130 is configured to place an article M by shoveling it up, the placement table 20 of the article relay apparatus 100 is provided with a notch having a shape that does not interfere with the article holder 133, as with the shelves 120. For example, each shelf 120 may have, on the top surface thereof, three pins that position the article M placed on the shelf 120 when inserted into three grooves formed on the bottom of the article M.

The transporter 130 travels in a direction perpendicular to the depth direction D using the travel part 140 and transfers an article M between shelves 120. The transporter 130 includes a base 131, an extension/retraction part 132, and the article holder 133. The base 131 is fixed to a platform 143 (to be discussed later). The extension/retraction part 132 is disposed on the base 131 so as to be able to extend and retract with respect to the shelves 120. The article holder 133 is disposed on an end of the extension/retraction part 132 and has an article M placed thereon. The article holder 133 can be moved in the depth direction D due to the extension or retraction of the extension/retraction part 132. For example, the article holder 133 may have, on the top surface thereof, three pins that position an article M placed on the article holder 133 when inserted into grooves formed on the bottom of the article M. Note that the transporter 130 need not be configured to have an article M placed thereon and may be configured, for example, to grasp the flange of an article M or to grasp the side surface of an article M.

The travel part 140 travels along rails 150 disposed along a direction perpendicular to the depth direction D. The travel part 140 includes bodies 141, a mast 142, and the platform 143. The rails 150 are disposed in parallel with the floor FL and the ceiling CL in the stocker. Each body 141 includes a travel driver (not shown). The mast 142 is disposed along the vertical direction between the upper and lower bodies 141. The mast 142 moves with the movement of the bodies 141. The platform 143 is disposed so as to be able to ascend and descend in the vertical direction along the mast 142. By setting the stop position of the travel part 140 and the ascent/descent position of the platform 143, the transporter 130 is allowed to receive or pass an article M from or to the placement table 20 or one of the shelves 120.

Next, the operation of the above stocker 200 will be described. First, a case in which the operator transports an article M into the stocker 200 will be described. In such a case, the controller of the stocker 200 is notified that the placement table 20 having the article M placed thereon has been located in the second position P2, by the article relay apparatus 100. The controller of the stocker 200 then locates the article holder 133 of the transporter 130 on the rear side in the depth direction D of the article relay apparatus 100 by driving the travel part 140 and the platform 143. After confirming that the shutters 61, 62 have been opened, the controller of the stocker 200 extends the extension/retraction part 132 to a front-side position in the depth direction D and causes the article holder 133 to receive and hold the article M on the placement table 20. Since the article M is located in the second position P2, the article holder 133 of the transporter 130 is able to easily and reliably hold the article M.

After holding the article M, the transporter 130 pulls the article holder 133 and the article M into the stocker interior K2 by retracting the extension/retraction part 132. The transporter 130 then moves the article holder 133 to a position corresponding to the destination shelf 120 by driving the travel part 140 and the platform 143. The transporter 130 then places the article M held by the article holder 133 on the shelf 120 by extending the extension/retraction part 132. Due to the above operation, the article M is transported onto the destination shelf 120.

Next, a case in which the operator transports an article M out of the stocker will be described. In such a case, the controller of the stocker 200 moves the article holder 133 to a position corresponding to a shelf 120 having thereon the article M to be transported out of the stocker 200 by moving the travel part 140 and the platform 143. The transporter 130 then causes the article holder 133 to receive and hold the article M from the shelf 120 by extending the extension/retraction part 132. The transporter 130 then locates the article holder 133 on the rear side in the depth direction D in the article relay apparatus 100 by driving the travel part 140 and the platform 143.

The controller of the stocker 200 then confirms that the shutters 61, 62 have been opened and that the placement table 20 having no article M placed thereon has been located in the second position P2. The controller of the stocker 200 then causes the transporter 130 to place the article M on the placement table 20 located in the second position P2 by extending the extension/retraction part 132 to the front side in the depth direction D. Since the placement table 20 is located in the second position P2, the transporter 130 is able to easily and reliably place the article M on the placement table 20.

The transporter 130 then pulls the article holder 133 into the stocker interior K2 by retracting the extension/retraction part 132. The controller of the stocker 200 notifies the article relay apparatus 100 that the article M has been placed on the placement table 20. Upon receipt of the notification, the article relay apparatus 100 closes the shutters 61, 62 and moves the placement table 20 from the second position P2 to the first position P1 by activating the movement mechanism 50. The operator then takes out the article M located in the first position P1. Thus, the transportation of the article M out of the stocker 200 is complete. At this time, the operator is able to visually recognize the article M on the placement table 20 located in the first position P1 obliquely from above and thus to easily check whether the article M is present.

As seen above, the stocker 200 of the present embodiment includes the above article relay apparatus 100. Thus, when the operator transports the article M into and out of the stocker 200, the visibility of the rear side of the opening 10 is improved, and the operator is able to easily check whether the article M is present. As a result, the workability of the operator who transports the article M into and out of the stocker 200 can be improved.

While the embodiment has been described above, the present invention is not limited to the above description. Various changes can be made to the embodiment without departing from the scope of the invention. The above stocker 200 is described with an example of a configuration in which at least one of the shelves 120 is disposed in the position that is on a rear side in the depth direction D from the first cover 30 and is above the placement table 20. However, the present invention is not limited to such a configuration. For example, there may be used a configuration in which no shelves 120 are disposed in the space that is on a rear side in the depth direction D with respect to the first cover 30 and is above the placement table 20.

The above embodiment is described with an example of a configuration in which the outside air inlets 71 are formed in the front surface of the second cover 40. However, such a configuration should not be considered limitative. For example, outside air inlets 71 may be formed in the side surface 42 of the second cover 40. For another example, outside air inlets 71 may be formed in the first cover 30.

The above embodiment is described with an example of a configuration in which the fan 73 is disposed on the rear side in the depth direction D of the opening 10. However, such a configuration should not be considered limitative. The fan 73 may be disposed on the front side in the depth direction D of the opening 10. Also, the outside air supplier 70 may be disposed in a side portion or lower portion of the apparatus interior K1 rather than in an upper portion of the apparatus interior K1. Also, a configuration in which the outside air supplier 70 is not provided may be applicable.

The above embodiment is described with an example of a configuration in which the first position P1 is on a rear side in the depth direction D with respect to the first cover 30. However, such a configuration should not be considered limitative. For example, the first position P1 may be a position on a front side in the depth direction D with respect to the first cover 30. The above embodiment is described with an example of a configuration in which the movement mechanism 50 is able to move the placement table 20 to the first position P1 in a direction toward the front side in the depth direction D. However, such a configuration should not be considered limitative. For example, the movement mechanism 50 may be able to move the placement table 20 to a position on a front side with respect to the first position P1 in the direction toward the front side in the depth direction D.

The above embodiment is described with an example of a configuration in which the position in which at least part of the article M placed on the placement table 20 is on a front side in the depth direction D with respect to the virtual plane S is set to the first position P1. However, such a configuration should not be considered limitative. For example, the first position P1 may be set to a position in which the entire article M placed on the placement table 20 is on a front side in the depth direction D with respect to the virtual plane S. Alternatively, the first position P1 may be set to a position in which the entire article M placed on the placement table 20 is on a rear side in the depth direction D with respect to the virtual plane S. The contents of Japanese Patent Application No. 2017-009445 and all documents cited in the present specification are incorporated herein by reference as a part of the present description to the extent permitted by law.

### Description of Reference Signs

- D: depth direction
- K2: stocker interior (facility interior)
- M: article
- P1: first position
- P2: second position
- R: passage
- S: virtual plane
- 10: opening
- 10a: upper end
- 20: placement table
- 30: first cover
- 40: second cover
- 41: slope
- 50: movement mechanism
- 60: shutter mechanism
- 61, 62: shutters
- 63: controller
- 70: outside air supplier
- 71: outside air inlet
- 72: duct
- 100: article relay apparatus
- 111: outside wall
- 120: shelf
- 130: transporter
- 200: stocker (facility)

## Claims

1. An article relay apparatus that is disposed on an outside wall separating an interior and an exterior of a facility and relays an article between the interior of the facility and an operator, the article relay apparatus comprising:
an opening that faces and is open to an operator passage located outside the outside wall;
a placement table that is disposed on a rear side in a depth direction with respect to the opening and on which an article is to be placed;
a first cover disposed in a position that is above the opening and is on a front side in the depth direction with respect to the opening, the first cover serving as a part of the outside wall; and
a second cover that is disposed between the first cover and the opening, serves as a part of the outside wall, and has a shape extending toward a rear side in the depth direction as going downward.

2. The article relay apparatus according to Claim 1, comprising a movement mechanism that moves the placement table between a first position that is on a front side in the depth direction and a second position that is on a rear side in the depth direction with respect to the first position and is a position in which an article is received from and passed to a transporter disposed in the interior of the facility.

3. The article relay apparatus according to Claim 2, wherein
the first position is a position in which at least part of an article placed on the placement table is on a front-side in the depth direction with respect to a virtual plane that includes an upper end of the opening and is in contact with the second cover, and
the second position is a position that is on a rear side in the depth direction with respect to the first position.

4. The article relay apparatus according to Claim 2 or 3, wherein the first position is a position that is on a rear side in the depth direction with respect to the first cover and is a front side limit position in the depth direction of the movement mechanism.

5. The article relay apparatus according to any one of Claims 1 to 4, comprising an outside air supplier that supplies outside air outside the outside wall to a rear side in the depth direction of the opening.

6. The article relay apparatus according to any one of Claims 1 to 5, wherein an outside air inlet of the outside air supplier is formed in a portion of the second cover.

7. A stocker comprising the article relay apparatus according to any one of Claims 1 to 6.

8. The stocker according to Claim 7, comprising a plurality of shelves on each of which the article is to be placed, the shelves being contained in the stocker, wherein
at least one of the shelves is disposed in a position that is on a rear side in the depth direction with respect to the first cover and is above the placement table.
